# EUROPÄISCHE PATENTANMELDUNG

(11) **EP 0 863 610 A2**
(43) Veröffentlichungstag der Anmeldung: **09.09.1998**
(21) Anmeldenummer: 97121813.6
(22) Anmeldetag: 11.12.1997
(51) Int. Cl.: H03G 3/00

(54) **Schaltung zur Regelung der Ausgangsleistung eines Hochfrequenzsenders**

(30) Priorität: 05.03.1997 DE 19708837
(71) Anmelder: ROBERT BOSCH GMBH, 70442 Stuttgart (DE)
(72) Erfinder: Mader, Thomas, Dr., 31139 Hildesheim (DE); Kottschlag, Gerhard, 31139 Hildesheim (DE); Pitz, Gerhard, Dr., 31139 Hildesheim (DE); Gallmann, Arnd, 47447 Moers (DE); Mevissen, Walter, 40227 Düsseldorf (DE)

(57) **Zusammenfassung**

Es wird eine Schaltung zur Regelung der Ausgangsleistung eines Hochfrequenzsenders, vorzugsweise für den Einsatz in einem Funktelefon, vorgeschlagen, wobei die Auskopplung eines Meßsignals auf einfache Art und Weise erfolgt.

## Beschreibung

### Stand der Technik

Die Erfindung geht aus von einer Schaltung zur Regelung der Ausgangsleistung eines Hochfrequenzsenders nach der Gattung des Hauptanspruchs.
Aus der DE-OS 42 25 821 ist eine Schaltung zur Regelung des Signalpegels eines Hochfrequenzsenders bekannt. In dieser bekannten Schaltung wird aus dem Ausgangssignal ein Meßsignal ausgekoppelt, das über eine Wandlerstufe einem Detektor zugeführt wird. Die am Senderausgang abgegebene Ausgangsleistung des Senders wird über das Meßsignal gemessen und als Regelgröße zur Korrektur des Fehlers im Signalpegel herangezogen. Als Koppler zur Auskopplung des Meßsignals wird im Stand der Technik ein Richtkoppler eingesetzt. Richtkoppler sind gegenüber reflektierten Wellen des Hochfrequenzsignals, die durch schlecht angepaßte Antennenschaltungen hervorgerufen werden, unempfindlich. Ihre Schaltung ist aufwendig und die Koppler selbst sind relativ große Bauelemente.

### Vorteile der Erfindung

Die erfindungsgemäße Schaltung mit den kennzeichnenden Merkmalen des Hauptanspruchs hat demgegenüber den Vorteil, daß mit einfachen Bauteilen wie einem Kondensator, einer Spule, oder einem Widerstand ein Meßsignal aus dem Ausgangssignal ausgekoppelt werden kann. Durch den Einsatz optimal angepaßter Antennen, die kaum rückläufige, reflektierte Wellen erlauben, ist diese einfache Auskopplung ohne Richtcharakteristik möglich. Es hat weiterhin den Vorteil, daß die Schaltung mit geringen Kosten und geringem Platzbedarf und Designaufwand realisiert werden kann.

Durch die in den Unteransprüchen aufgeführten Maßnahmen ist eine vorteilhafte Weiterbildung und Verbesserung der im Hauptanspruch angegebenen Schaltung möglich.

Der Koppelfaktor, der die Größe der ausgekoppelten Signalleistung kennzeichnet, muß so gewählt werden, daß keine Beeinträchtigung des Abschlußwiderstandes erfolgt. Weiterhin ist es von Vorteil, wenn nur soviel Signalleistung ausgekoppelt wird, wie zur Ansteuerung der Regelung nötig ist, ohne daß zuviel Sendeleistung verloren geht.

### Zeichnung

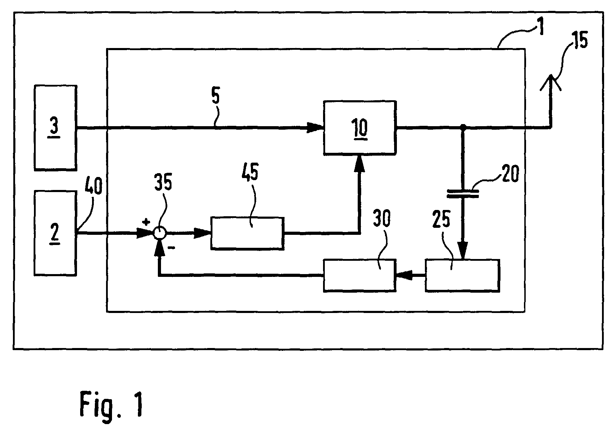

Ein Ausführungsbeispiel der Erfindung ist in der Zeichnung dargestellt und in der nachfolgenden Beschreibung näher erläutert. Es zeigt Figur 1 die erfindungsgemäße Regelungsschaltung.

### Beschreibung des Ausführungsbeispiels

Figur 1 zeigt die Regelschaltung 1, die an einem Eingang mit einer Steuereinheit 2 sowie am anderen Eingang mit einem Steuersender 3 verbunden ist. Der Steuersender 3 ist mit dem HF-Eingang des Sendeverstärkers 10 verbunden, dessen Ausgang an einer Antenne 15 anliegt. Abzweigend vom Ausgang des Sendeverstärkers 10 geht der Regelungszweig ab. Das Koppelelement 20 verbindet den Ausgang des Sendeverstärkers 10 mit einem Detektor 25, der über ein Filter 30 mit dem invertierenden Eingang eines Summierpunkts 35 verbunden ist. Am nicht invertierenden Eingang des Summierpunkts liegt der Ausgang der Steuereinheit 2 an. Der Ausgang des Summierpunkts 35 ist über ein zweites Filter 45 am Steuereingang des Sendeverstärkers 10 angeschlossen.

Ein vom Steuersender 3 oder ggf. von Treiber bzw. Filterstufen kommendes Hochfrequenzsendesignal 5 liegt am Eingang der Sendeverstärkung 10 an. Dessen Ausgangssignal ist mit der Sendeantenne 15 verbunden. Aus dem Ausgangssignal wird über das Koppelelement, z.B. den Kondensator 20 Sendeenergie ausgekoppelt. Als Detektor können beispielsweise einfache Dioden-Detektoren eingesetzt werden. Das nach dem Detektor 25 als Gleichspannungssignal vorliegende Regelsignal erreicht den invertierenden Eingang des Summierpunktes 35. Über den zweiten, nicht invertierenden Eingang des Summierpunktes 35 wird eine analoge Steuerspannung 40 zur Anhebung bzw. Absenkung des Sendesignalpegels eingespeist. Der Ausgang des Summierpunkts 35 ist über ein zweites Filter 45 an dem Leistungssteuerungseingang des Sendeverstärkers 10 angeschlossen. Das Filter 45 verschleift noch vorhandene Stufen des Steuersignals 40 der Steuereinheit 2 in einen kontinuierlichen Spannungsverlauf. Die Stufen werden von einer Digital/Analogwandlung des digitalen Signals eines Prozessors erzeugt. Prozessor und Digital/Analogwandler sind Teile der Steuereinheit und nicht getrennt dargestellt. Der Wandlertakt wird weggefiltert, da sonst Störspektren im Nutzsignal auftauchen würden. Mit der analogen Steuerspannung 40 wird die gewünschte Sendeleistung für das Funktelefongerät vorgegeben. Von der tatsächlich erzeugten Sendeleistung wird ein kleiner Teil vom Auskoppelkondensator 20 aus dem Sendepfad abgezweigt und dem Detektor 25 zugeführt. Der ermittelte Meßwert wird in die Pegelsteuerung zurückgeführt, wodurch das Sendesignal auf den gewünschten Wert nachgeregelt wird. Die beiden Filter 30 und 45 verhindern eine Schwingneigung des Regelkreises. Die Filter müssen dabei nicht notwendigerweise als separate Bauteile ausgeführt sein. Der Steuereingang des Leistungsverstärkers hat bereits eine Tiefpaßcharakteristik.
Bei guter Anpassung des Wellenwiderstands zeigt die Schaltung eine ausreichende Meßgenauigkeit. Die gute Anpassung des Wellenwiderstands ist bei einem Einsatz in einem Fahrzeug und der Verwendung der Fahrzeugantenne ohne Probleme möglich.

## Patentansprüche

1. Schaltung zur Regelung der Ausgangsleistung eines Hochfrequenzsenders, vorzugsweise für ein in einem Fahrzeug eingebautes Funkgerät, mit einem regelbaren Senderverstärker (10) mit einer daran anschließbaren Antenne (15), einem Koppelelement (20) am Ausgang des Sendeverstärkers (10), einem Detektor (25) für das ausgekoppelte Signal und einer Steuereinheit (2), die mit dem Detektor verbunden ist und über einen Steuereingang den Senderverstärker (10) regelt, dadurch gekennzeichnet, daß die Antenne (15) eine der Schaltung angepaßte Impedanz aufweist und daß das Koppelelement ein einzelner Kondensator (20) oder eine Spule oder ein Widerstand ist.

2. Schaltung zur Regelung der Ausgangsleistung nach Anspruch 1, dadurch gekennzeichnet, daß der Koppelfaktor des Koppelelements so groß ist, daß die Abschlußimpedanz im wesentlichen dem Nominalwert entspricht.

3. Schaltung zur Regelung der Ausgangsleistung nach Anspruch 1 oder 2, dadurch gekennzeichnet, daß der Koppelfaktor des Koppelelements so groß ist, daß die Ansteuerung der Regelung möglich ist.

4. Schaltung zur Regelung der Ausgangsleistung nach Anspruch 1 bis 3, dadurch gekennzeichnet, daß der Koppelfaktor des Koppelelements so groß ist, daß wenig Sendeleistung verloren geht.
